(19) Europäisches Patentamt

European Patent Office

Office européen des brevets

(11) Veröffentlichungsnummer: **0 253 066**

**A2**

(12) **EUROPÄISCHE PATENTANMELDUNG**

(21) Anmeldenummer: **87105022.5**

(22) Anmeldetag: **04.04.87**

(51) Int. Cl.⁴: **G03F 1/00**

(30) Priorität: **12.07.86 DE 3623637**

(43) Veröffentlichungstag der Anmeldung:
**20.01.88 Patentblatt 88/03**

(84) Benannte Vertragsstaaten:
**AT CH FR GB IT LI NL SE**

(71) Anmelder: **Kernforschungszentrum Karlsruhe GmbH**
**Weberstrasse 5 Postfach 3640**
**D-7500 Karlsruhe 1(DE)**

(72) Erfinder: **Ehrfeld, Wolfgang, Dr.**
**Reutstrasse 27**
**D-7500 Karlsruhe 41(DE)**
Erfinder: **Götz, Friedrich, Dr.**
**Rintheimer Hauptstrasse 101**
**D-7500 Karlsruhe 1(DE)**
Erfinder: **Münchmeyer, Dietrich, Dr.**
**Hagäckerstrasse 5**
**D-7513 Stutensee-3(DE)**

(54) **Verfahren zur Herstellung von Mikrostrukturen unterschiedlicher Strukturhöhe mittels Röntgentiefenlithographie.**

㊼ Die Erfindung betrifft ein Verfahren zur Herstellung von Mikrostrukturen mit bereichsweise unterschiedlicher Strukturhöhe aus einem gegenüber Röntgenstrahlung empfindlichen Positiv-Resistmaterial mittels Röntgentiefenlithographie mit Synchrotronstrahlung unter Verwendung von Röntgenmasken mit den Mikrostrukturen entsprechenden Absorberstrukturen. Der Erfindung liegt die Aufgabe zugrunde, bei einem Verfahren der gattungsgemäßen Art einen Weg aufzuzeigen, durch den die gewünschten unterschiedlichen Strukturhöhen in dem Resistmaterial mit nur einem Lithographieschritt erzeugt werden können.

Diese Aufgabe wird dadurch gelöst, daß nur eine Röntgenmaske verwendet wird, die zusätzlich zu der strukturierten Absorberschicht, die die Synchrotronstrahlung weitestgehend absorbiert (Totalabsorberschicht), mindestens eine weitere strukturierte Absorberschicht trägt, die die Synchrotronstrahlung bevorzugt nur in einem Teil des Spektrums absorbiert (Partialabsorberschicht) und als Positiv-Resistmaterial ein Polymer mit scharfer unterer Grenzdosis verwendet wird.

EP 0 253 066 A2

## Verfahren zur Herstellung von Mikrostrukturen unterschiedlicher Strukturhöhe mittels Röntgentiefenlithographie

Die Erfindung betrifft ein Verfahren zur Herstellung von Mikrostrukturen gemäß dem Oberbegriff von Anspruch 1.

Verfahren zur Herstellung von Mikrostrukturen mittels Röntgentiefenlithographie sind beispielweise in dem KfK-Bericht 3995 "Herstellung von Mikrostrukturen mit großem Aspektverhältnis und großer Strukturhöhe durch Röntgenlithographie mit Synchrotronstrahlung, Galvanoformung und Kunststoffabformung (LIGA-Verfahren)" von E. W. Becker, W. Ehrfeld, P. Hagmann, A. Maner, D. Münchmeyer, Kernforschungszentrum Karlsruhe, November 1985, beschrieben. Damit können Mikrostrukturen mit lateral frei wählbarer Form bei einheitlicher Strukturhöhe hergestellt werden.

Ein Verfahren der gattungsgemäßen Art, mit dem auch Mikrostrukturen mit zwei Bereichen unterschiedlicher Strukturhöhe hergestellt werden können, ist für den speziellen Fall säulenförmiger Strukturen mit einen dünneren, längeren und einem dickeren, kürzeren Abschnitt aus der DE-PS 34 40 110 bekannt. Dabei wird eine Resistplatte von ca. 0,5 mm Dicke über eine Röntgenmaske mit energiereicher Röntgenstrahlung eines Synchrotrons partiell durchstrahlt in der Weise, daß zylindrische Bereiche mit einem Durchmesser von ca. 30 $\mu$m in einem vorgegebenen Rasterabstand r entstehen, deren Löslichkeit gegenüber den unbestrahlten Bereichen der Resistplatte stark erhöht ist. Sodann erfolgt eine weitere partielle Bestrahlung der Resistplatte von einer Seite her im selben Raster r, wobei die Eindringtiefe der Strahlung jedoch geringer ist als die Resistplattenstärke und der Durchmesser der bestrahlten Bereiche ca. 70 $\mu$m beträgt, so daß ein dickerer und kürzerer zylindrischer bestrahlter Bereich entsteht. Die derart bestrahlten und löslich gemachten Be reiche werden mit einem beispielsweise in der DE-OS 30 39 110 beschriebenen flüssigen Entwickler entfernt. Dadurch entsteht eine Form mit säulenförmigen Strukturen, die einen dünneren und einen dickeren Abschnitt aufweisen.

Dieses Verfahren läßt sich prinzipiell auf die Herstellung von Mikrostrukturen mit anderen lateralen Konturen und auch mit mehr als zwei unterschiedlichen Strukturhöhen übertragen.

Bei der Durchführung dieses Verfahrens ist für jede Strukturhöhe ein eigener Bestrahlungsschritt erforderlich; für jeden Bestrahlungsschritt muß eine gesonderte Maske bereitgestellt werden, und diese muß jeweils mit hoher Präzision relativ zu den bereits bestrahlten Bereichen des Resists justiert werden.

Gegenüber der Herstellung von Mikrostrukturen mit einheitlicher Strukturhöhe ergibt sich deswegen bei der Anwendung dieses Verfahrens zur Herstellung von Mikrostrukturen mit bereichsweise unterschiedlicher Strukturhöhe ein höherer Aufwand und eine verminderte Ausbeute.

Der Erfindung liegt die Aufgabe zugrunde, bei einem Verfahren der gattungsgemäßen Art einen Weg aufzuzeigen, durch den die gewünschten unterschiedlichen Strukturhöhen in dem Resistmaterial mit nur einem Lithographieschritt erzeugt werden können.

Diese Aufgabe wird mit den im Kennzeichen von Anspruch 1 genannten Maßnahmen gelöst.

Mit dem erfindungsgemäßen Verfahren können komplizierte Mikrostrukturen auf rationelle Weise mit hoher Genauigkeit hergestellt werden.

Die Erfindung macht von der Eigenschaft bestimmter, relativ leichter Elemente Gebrauch, die das Spektrum der bei der Röntgenlithographie eingesetzten Synchrotronstrahlung oberhalb einer diskreten Energie stark absorbieren. In Kombination mit der unteren Grenzdosis des Resistmaterials können auf diese Weise Mikrostrukturen erzeugt werden, die eine Vielzahl unterschiedlicher und vorher bestimmbarer Abstufungen aufweisen, wobei auch die lateralen Flächen der Stufen keine nennenswerten Unebenheiten aufweisen.

In einem anderen Zusammenhang wird von E. Spiller und R. Feder in X-Ray Optics", herausgegeben von H.-J. Queisser, Springer-Verlag Berlin, Heidelberg, New York, 1977, Seite 69, letzter Absatz, erwähnt, daß Masken aus verschiedenen Röntgenstrahlenabsorbern, die selektiv verschiedene Röntgenwellenlängen absorbieren, auf der Rückseite eines Wafers gemacht werden könnten. Damit könnten bei geeigneter Wahl von Wellenlänge und Intensität mehrere Muster selektiv auf die Vorderseite des Wafers übertragen werden, wodurch der Einfluß des Wafer-Verzugs eliminiert wird. Eine Anregung, mit Röntgenstrahlenabsorbern dieser Art Mikrostrukturen unterschiedlicher Strukturhöhen in einem dicken Resist im Sinne der Erfindung zu erzeugen, ist dieser Literaturstelle nicht zu entnehmen.

Mit dem erfindungsgemäßen Verfahren läßt sich z. B. die o. g. Erzeugung von säulenförmigen Resistsstrukturen bei der Herstellung von mechanisch trennbaren Vielfach-Verbindungen für den Anschluß mikroelektronischer Bauelemente erheblich vereinfachen. Dieses Beispiel zeigt auch, wie aus den mit der Röntgenlithographie erzeugten Kunststoffstrukturen entsprechende Strukturen aus anderen Materialien, z. B. Metall, erzeugt werden können.

Andere Anwendungen für das erfindungsgemäße Verfahren liegen beispielsweise bei der Herstellung von Mikrosieben mit Verstärkungsstegen, wobei Mikrostrukturen hergestellt werden, die im Bereich der Verstärkungsstege eine größere Strukturhöhe erhalten als im Bereich der Sieblöcher. Damit läßt sich die für die Verstärkungsstege benötigte Fläche bei gleicher Festigkeit reduzieren und damit die Filtertransparenz verbessern.

Ein Ausführungsbeispiel der Erfindung wird im folgenden anhand der Zeichnungen näher erläutert.

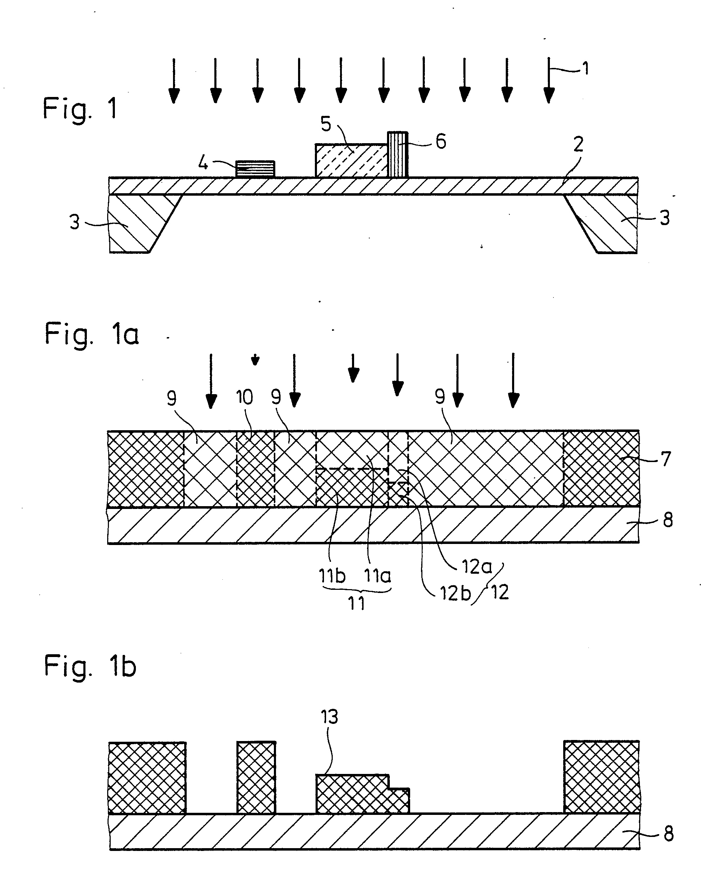

Die Figur 1a veranschaulicht die Bestrahlung eines Positiv-Resists über eine Röntgenmaske mit Absorberstrukturen aus drei verschiedenen Materialien;

die Figur 1b zeigt die dabei erzeugten Mikrostrukturen nach der Bestrahlung und der Entwicklung.

Die Röntgenmaske gemäß Figur 1a besteht aus einer für die verwendete Synchrotronstrahlung (Pfeile 1) weitgehend transparenten Trägerfolie 2 aus Beryllium, die in einem Halterahmen 3 straff gespannt ist und Absorberstrukturen aus Gold 4, aus Aluminium 5 und aus Siliziumdioxid 6 trägt. Die für die Bestrahlung verwendete Synchrotronstrahlung hat eine breite spektrale Verteilung mit einer charakteristischen Wellenlänge bei ca. 0,8 nm. Der Positiv-Resist 7 besteht aus einer bis zu 0,5 mm dicken Platte aus vernetztem Polymethylmethacrylat (PMMA), die auf einer Grundplatte 8 aufgebracht ist.

Die Absorberstrukturen aus Gold 4 (Totalabsorberschicht) absorbieren die Synchrotronstrahlung 1 weitestgehend. Die Absorberstrukturen aus Aluminium 5 (erste Partialabsorberschicht) absorbieren die Synchrotronstrahlung 1 bei Wellenlängen, die kürzer sind als die Wellenlänge der K -Absorptionskante von Aluminium bei 0,83 nm, weitgehend, während längere Wellenlängen nur geringfügig absorbiert werden. Entsprechend werden durch die Absorberstrukturen aus SiO$_2$ (zweite Partialabsorberschicht) Wellenlängen, die kürzer als 0,71 nm sind, weitgehend absorbiert, während längere Wellenlängen nur geringfügig absorbiert werden.

Der Positiv-Resist 7 weist eine scharfe untere Grenzdosis auf; das bedeutet, daß das Resistmaterial exakt bei dieser abgelagerten Strahlendosis im Entwickler löslich wird, unterhalb dieser Strahlendosis jedoch vom Entwickler nicht angegriffen wird.

In den Bereichen 9, die nicht durch Absorberstrukturen 4, 5, 6 abgeschattet werden, erhält der Resist 7 bei der Bestrahlung entlang seiner gesamten Dicke eine Dosis, die höher ist als die untere Grenzdosis des Resistmaterials. In dem Bereich 10, der durch Absorberstrukturen aus Gold 4 abgeschattet wird, erhält der Resist 7 bei der vorerwähnten Bestrahlung entlang seiner gesamten Dicke eine Dosis unterhalb der Grenzdosis des Resistmaterials. In dem Bereich 11, der durch die Absorberstrukturen aus Aluminium 5 abgeschattet wird, wird bei der Bestrahlung nur im oberen Teil 11a eine Dosis abgelagert, die größer als die untere Grenzdosis des Resistmaterials ist; der untere Teil 11b erhält eine geringere Dosis. Dies liegt daran, daß die Eindringtiefe von Röntgenstrahlung mit abnehmender Wellenlänge zunimmt und durch die Absorberstrukturen aus Al der kurzwellige Teil des Spektrums, der wesentlich zur Dosisablagerung in den tieferen Resistschichten beiträgt, weitgehend unterdrückt wurde. In entsprechender Weise wird auch in dem durch die Absorberstrukturen aus SiO$_2$ 6 abgeschatteten Bereich 12 nur in einem oberen Teil 12a eine über der Grenzdosis liegende Dosis bei der Bestrahlung abgelagert, während im unteren Teil 12b die Grenzdosis nicht erreicht wird. Da die Absorberkante von Si bei einer kürzeren Wellenlänge (0,71 nm) liegt als bei Al (0,83 nm), enthält das von den SiO$_2$-Absorberstrukturen durchgelassene Spektrum mehr kurzwellige Anteile, wodurch die Grenze zwischen den Teilen 12a und 12b weiter unten im Resist 7 liegt, verglichen mit der Grenze zwischen den Teilen 11a und 11b.

Bei der Entwicklung im Entwicklerbad werden entsprechend der vorgenannten Eigenschaft des Resistmaterials alle Bereiche 9, 11a, 12a, die eine höhere Dosis als die untere Grenzdosis erhalten haben, aufgelöst, so daß eine Mikrostruktur 13 mit unterschiedlicher Strukturhöhe entsteht (Fig. 1b). Dabei entsprechen jeweils die lateralen Konturen der Bereiche gleicher Strukturhöhe den lateralen Konturen der zugeordneten Absorberstrukturen auf der Röntgenmaske.

Anstelle oder zusätzlich zu den im Ausführungsbeispiel genannten Materialien Al und SiO$_2$ können auch die in Anspruch 3 genannten Materialien als Partialabsorberschichten eingesetzt werden, um andere Abstufungen der Strukturhöhen der Mikrostrukturen zu erzielen. Die Absorptionskanten einiger dieser Materialien sind in der folgenden Tabelle zusammengestellt:

| Z | Material | Absorptionskante bei (nm) |
|---|---|---|
| 11 | Na | 1.19 |
| 12 | Mg | 0.99 |
| 13 | Al | 0.83 |
| 14 | Si | 0.71 |
| 15 | P | 0.61 |
| 16 | S | 0.53 |
| 17 | Cl | 0.47 |

Die Herstellung einer Röntgenmaske mit z. B. zwei strukturierten Absorberschichten aus Al (Partialabsorberschicht) und Au (Totalabsorberschicht) geschieht, indem man zuerst die der verminderten Strukturhöhe der Mikrostruktur entsprechende strukturierte Al-Schicht auf einer für die verwendete Röntgenstrahlung weitgehend transparente Trägerfolie aus Be aufbringt, und auf der Al-Schicht dann die Totalabsorber schicht aus Au. Die Strukturierte Al-Schicht umfaßt dabei nicht nur die der verminderten Strukturhöhe entsprechenden Bereiche, sondern auch die Bereiche, die der vollen Strukturhöhe entsprechen und durch Au abgeschattet werden müssen. Damit ist an allen Stellen, an denen Au aufgebracht werden muß, bereits die Al-Schicht vorhanden und die Totalabsorberschicht aus Au kann anschließend auf der Al-Schicht aufgebracht werden. Die Al-Schicht stört an diesen Stellen die Funktion der Maske nicht, da sie Wellenlängenbereiche unterdrückt, die ohnehin durch die Totalabsorberschicht aus Au unterdrückt werden. Diese Herstellungsfolge läßt sich auf Masken mit mehr als zwei strukturierten Absorberschichten erweitern, wobei die Schichten in der Reihenfolge zunehmender Strukturhöhe der damit zu erzeugenden Mikrostrukturbereiche aufgebaut werden.

## Ansprüche

1. Verfahren zur Herstellung von Mikrostrukturen mit bereichsweise unterschiedlicher Strukturhöhe aus einem gegenüber Röntgenstrahlung empfindlichen Positiv-Resistmaterial mittels Röntgentiefenlithographie mit Synchrotronstrahlung unter Verwendung von Röntgenmasken mit den Mikrostrukturen entsprechenden Absorberstrukturen (strukturierte Absorberschicht),
dadurch gekennzeichnet, daß
a) nur eine Röntgenmaske verwendet wird, die zusätzlich zu der strukturierten Absorberschicht, die die Synchrotronstrahlung weitestgehend absorbiert (Totalabsorberschicht), mindestens eine weitere strukturierte Absorberschicht trägt, die die Synchrotronstrahlung bevorzugt nur in einem Teil des Spektrums absorbiert (Partialabsorberschicht),
und
b) als Positiv-Resistmaterial ein Polymer mit scharfer unterer Grenzdosis verwendet wird.
2. Verfahren nach Anspruch 1, dadurch gekennzeichnet, daß die Partialabsorberschichten Elemente enthalten, die im Spektralbereich der verwendeten Synchrotronstrahlung eine Absorptionskante aufweisen.
3. Verfahren nach Anspruch 2, dadurch gekennzeichnet, daß die Partialabsorberschichten wenigstens eines der Elemente Na, Mg, Al, Si, P, S oder Cl enthalten, und zwar entweder in elementarer Form oder als Verbindungen oder Legierungen mit den leichten Elementen Be, B, C, N, O, F.
4. Verfahren nach Anspruch 1, dadurch gekennzeichnet, daß als Positiv-Resistmaterial mit scharfer unterer Grenzdosis vernetztes Polymethylmethacrylat verwendet wird.

Fig. 1

Fig. 1a

Fig. 1b